# EUROPEAN PATENT APPLICATION

(11) **EP 1 531 334 A2**
(43) Date of publication of application: **18.05.2005**
(21) Application number: 04300774.9
(22) Date of filing: 09.11.2004
(51) Int. Cl.: G01R 21/00

(54) **Electrical power measuring devices**

(30) Priority: 13.11.2003 GB 0326519
(71) Applicant: Actaris UK Limited, Felixstowe, Suffolk IP11 2ER (GB)
(72) Inventor: Brown, Scott, Saxmundham, Suffolk IP17 1BE (GB); Chen, Chun, Ipswich IP1 2 (GB)
(74) Representative: Feray, Valérie

(57) **Abstract**

The present invention relates to the field of electrical power meter utilizing digital signal processing in order to provide the consumption of electrical energy by integration of said electrical power. Said meter 1 comprises a voltage sensor 4 in order to generate an analogue voltage signal responsive to a voltage provided to said load, a current sensor 3 in order to generate an analogue current signal responsive to a current provided to said load, an analogue to digital converter 8 including first sampling means for generating a first voltage sample based on said analogue voltage signal at a first sampling time and second sampling means for generating a first current sample based on said analogue current signal at a second sampling time. Said meter 1 further comprises phase compensation means 9 for compensating phase shifts between said analogue voltage and current signals by adjusting said second sampling time compared to said first sampling time in order to provide said first voltage sample and said first current sample substantially in phase and means for memorizing 11 either at the same time said first voltage sample and a second voltage sample immediately following the sampling of said first voltage sample or at the same time said first current sample and a second current sample immediately following the sampling of said first current sample.

## Description

The present invention relates to the field of electrical power meter utilizing digital signal processing in order to provide the consumption of electrical energy by integration of said electrical power.

It is well known to provide electrical utility meter allowing the measurement of electrical energy consumed by a facility. Such a meter converts analogue signals proportional to current and voltage in the power line being metered to digital signals for digital signal processing. Such a conversion step is provided by an analogue to digital converter. The digital signals can then be readily multiplied and the product of multiplication provides the electrical power. The electrical power is then provided to an accumulator which generates pulses proportional to the power used on the power line being metered.

One problem encountered by such a known electrical utility meter is that the accuracy of such meter requires that the voltage and current signals be in the correct phase relationship before each is provided to the analogue to digital converter. That is, the phase relationship should accurately represent the phase relationship in the power line. However, the voltage and current filtering, amplification and isolation are accomplished through circuitry including instrument transformers and other circuit elements which may introduce phase differences or errors between them.

A known solution to this problem, in order to obtain the required accuracy and to compensate for manufacturing errors in the instrument transformers and changes in circuit elements with time and environmental exposure, is to provide phase compensating means for the electrical meter. Such a solution is disclosed in the document US5017860 which discloses a meter comprising compensation means to adjust the time of sampling of one signal (current or voltage) relative to the other to compensate the phase shifts in the system and provide a more accurate indication of power used on the power line.

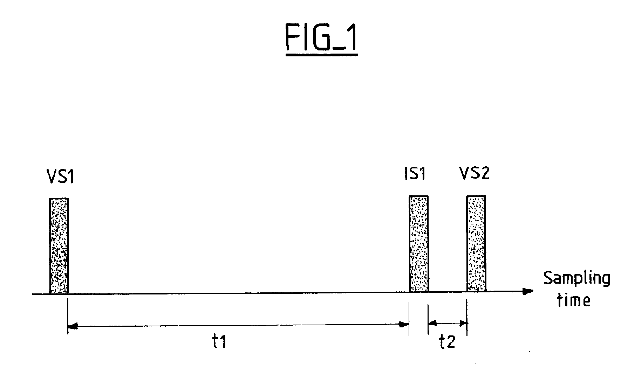

However, this solution raises some difficult problems illustrated in figure 1. Figure 1 shows first and second voltage samples VS1 and VS2 and a first current sample IS1 represented as a function of time. Because of phase compensation, there is an adjustment by t1 of the time of sampling the analogue current signal compared to the time of sampling the analogue voltage signal. This adjusting time t1 may be quite long; for instance, t1 may represent about 880 µs. By taking a sampling rate of 1024 samples/second, this provides a sample window of only 976 µs. Thus, there is only a very short time t2 (here 96 µs) to perform the power calculation VS1xIS1 because it has to be done before the next sampled voltage value VS2 is required. Experimentations have shown that it is not always sufficient, depending on the calculations needed; for instance, a larger time is needed when 1 kWh of energy is accumulated. In such a case, there is a risk of interruption of calculations.

One object of the present invention is to provide a meter for metering the eleclrical power on a power load that allows good measurement accuracy while having enough time to perform the calculations with low risk of interruption.

More precisely, the present invention provides a meter for metering the electrical power comprising:
- a voltage sensor in order to generate an analogue voltage signal responsive to a voltage provided to said load,
- a current sensor in order to generate an analogue current signal responsive to a current provided to said load,
- an analogue to digital converter including:
   o first sampling means for generating a first voltage sample based on said analogue voltage signal at a first sampling time,
   o second sampling means for generating a first current sample based on said analogue current signal at a second sampling time,
- phase compensation means for compensating phase shifts between said analogue voltage and current signals by adjusting said second sampling time compared to said first sampling time in order to provide said first voltage sample and said first current sample substantially in phase,
said meter being characterized in that it further comprises means for memorizing either at the same time said first voltage sample and a second voltage sample Immediately following the sampling of said first voltage sample or at the same time said first current sample and a second current sample immediately following the sampling of said first current sample.

Thus, by use of this meter, two successive sampled voltage values are stored in memorizing means such as a FIFO (First In First Out) buffering memory. In such a case, said FIFO buffer has to hold two voltage samples at the same time. Therefore, it is possible to multiply first sampled current and voltage values after the second sampled voltage value has already been performed and received by said buffer. According to the invention, there is thus a larger window of time to perform the calculation with a low risk for interruptions.

Advantageously, said means for memorizing are a First In First Out buffer with two memorizing location in order to allow memorizing of two voltage samples at the same time.

Advantageously, said means for memorizing are software means.

Advantageously, said meter comprises a microcontroller, said means for memorizing being integrated in said microcontroller.

Advantageously, said phase compensation means are a timer integrated in said analogue to digital converter.

Other characteristics and advantages of the invention will appear reading the following description of an embodiment of the invention, given by way of example and with reference to the accompanying drawings, in which:
- Figure 1 shows schematically some current and voltage samples data stream versus time performed with a meter according to the prior art,
- Figure 2 shows schematically a block diagram of a meter according to the present invention,
- Figure 3 shows schematically some current and voltage samples data stream versus time performed with a meter according to the invention.

Figure 1 has already been described by reference to the prior art.

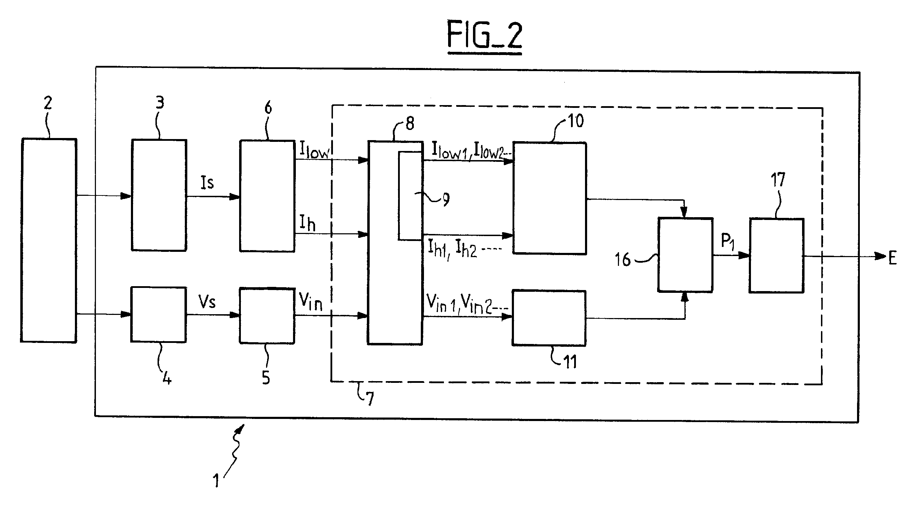

Figure 2 shows schematically a meter 1 according to the invention.

In general, said meter 1 is operably connected to a power lines load 2 uf a power consuming facility, not shown, such as a residence or industrial establishment.

The meter 1 comprises:
- a current sensor 3,
- a voltage sensor 4,
- voltage level adjustment means 5,
- current level adjustment means 6,
- a microcontroller 7.

Said microcontroller 7 includes :
- an analogue to digital A/D converter 8 including a timer 9,
- an input selector 10,
- a FIFO buffer 11,
- a multiplier 16,
- an integrator 17.

The voltage sensor 4 is connected to the power lines 2 and is operable to generate a voltage measurement signal Vs representative of the voltage waveform on the power lines 2. Said voltage sensor 4 may be for instance a simple resistor divider. The Vs signal is then adjusted by the voltage level adjustment means 5 outputting an adjusted voltage measurement signal Vin. Said voltage level adjustment means 5 are used in order to provide a correct signal level to the A/D converter 8. One has to note that said voltage level adjustment means 5 might also have a filtering function.

The current sensor 3 is also connected to the power lines 2 and is operable to generate a current measurement signal ls representative of the current waveform on the power lines 2. Said current sensor may be for instance a shunt resistance used to derive the current. The Is signal is then adjusted by the current level adjustment means 6 outputting two adjusted current measurement signals llow and lh. The lh and llow signals represent the same Is signal respectively adjusted with two different gains A1 and A2. This allows a good A/D converter inputs range across the whole current range (for instance 10 mA to 100 A). A1 is for example used to produce the appropriate signal lh for main currents of 4 to 100 A and A2 is used to produce the appropriate signal llow for main currents of 10 mA to 4 A. As for the voltage adjustment means 5, one has to note that the current adjustment means 6 may also have a filtering function.

The A/D converter 8 generates a sampled voltage measurement data stream comprising a plurality of voltage measurement samples Vin1, Vin2, Vin3,... based on the voltage measurement signal Vin provided by the voltage adjustment means 5.

Identically, said A/D converter 8 generates a first sampled current measurement data stream comprising a plurality of current measurement samples Ih1, lh2, lh3,... based on the current measurement signal lh provided by the current adjustment means 6 and a second sampled current measurement data stream comprising a plurality of current measurement samples llow1, llow2, Ilow3,... based on the current measurement signal llow provided by the current adjustment means 6.

One problem is that adjustment and filtering steps introduce phase shifts in the different analogue signals; such phase shifts have to be taken into account when sampling the signals. Such a situation is particularly true with the current adjustment means 6 used to adjust the signal Is. The adjustment provided by the current adjustment means 6 causes some phase shifting of lh and llow and further phase shifting occurs when low-pass filtering is added to the signal in order to reduce the noise and improve the signal-to-noise ratio; this last point is critical in case of llow that is extremely shifted in phase. Therefore, there is always a first phase shift that is not very high between Vin and lh and a second higher phase shift between Vin and llow.

In order to get voltage and current samples corresponding to voltage and current signals that are substantially in phase, the A/D converter comprises a timer 9 for compensating phase shifts between said analogue voltage Vin and said current signal lh and between said analogue voltage Vin and said current signal llow. Such compensation is obtained by adjusting the sampling time of lh and llow compared to the sampling time of Vin in order to provide a voltage sample Vin1 and current samples llow1 and Ih1 substantially in phase.

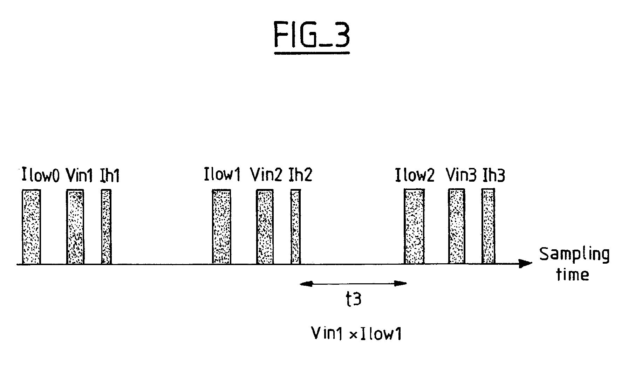

Figure 3 represents some successive voltage samples Vin1 to Vin3, some successive current samples Ih1 to lh3 and some successive current samples llow0 to llow2. For example, Vin1, llow1 and Ih1 represent three samples corresponding to analog signals substantially in phase. As already mentioned above with reference to the figure 1, the adjusting time may be quite long. This is particularly true for the adjusting time representing the difference between Vin1 and llow1, i.e. between the sampling time of Vin and the sampling time of llow that may represent about 880 µs.

The role of the input selector 10 is to select one of the two current samples, between for instance Ih1 and llow1, that is going to be used for the calculation of the power. Such a selection is based on the level of Ih1 and llow1. Let's assume that llow1 is selected.

Two successive voltage samples, for instance Vin1 and Vin2, are memorized at the same time in the FIFO buffer 11. Such a FIFO buffer is a software-based buffer integrated in the microcontroller 1.

The samples Vin1 and llow1 provide the inputs to the multiplier 16 which multiplies Vin1 by llow1 to provide a digital input signal P1 to the integrator 17 that is going to provide an accumulated energy E.

According to the invention, the multiplier 16 is not obliged to make the calculation of Vin1xllow1 before the next sample Vin2 is required because Vin1 is memorized in the buffer 11 while the next sample Vin2 has already been received by the buffer 11.

By using the FIFO buffer 11 holding at the same time Vin1 and the next voltage samples Vin2, the calculation of Vin1xllow1 may be done during a period t3, represented in figure 3, that goes from the providing of the next current sample lh2 following the sample Ih1 until the next current sample llow2 following the sample llow1.

This period t3 corresponds to a large window of time to perform the calculation of Vin1xllow1.

Naturally, the present Invention is not limited to the example and embodiment described and shown, and the invention can be the subject to numerous variants that are available to the person skilled in the art.

For instance, said means for memorizing at the same time said first voltage sample and a second voltage sample immediately following the sampling of said first voltage sample has been described as being software means integrated in the microcontroller but it may also be based on hardware solution.

Besides, the meter according to the invention has been described as having two types of current signals Ih and llow but it may also have only one type of current

## Claims

1. Meter (1) for metering the electrical power comprising:
- a voltage sensor (4) in order to generate an analogue voltage signal responsive to a voltage provided to said load,
- a current sensor (3) in order to generate an analogue current signal responsive to a current provided to said load,
- an analogue to digital converter (8) including:
o first sampling means for generating a first voltage sample based on said analogue voltage signal at a first sampling time,
o second sampling means for generating a first current sample based on said analogue current signal at a second sampling time,
- phase compensation means (9) for compensating phase shifts between said analogue voltage and current signals by adjusting said second sampling time compared to said first sampling time in order to provide said first voltage sample and said first current sample substantially in phase,
said meter being **characterized in that** it further comprises means for memorizing (11) either at the same time said first voltage sample and a second voltage sample immediately following the sampling of said first voltage sample or at the same time said first current sample and a second current sample immediately following the sampling of said first current sample.

2. Meter (1) according to claim 1 **characterized in that** said means for memorizing (11) are a First In First Out buffer with two memorizing location in order to allow memorizing of two voltage samples at the same time.

3. Meter (1) according to claim 1 or claim 2 **characterized in that** said means for memorizing are software means.

4. Meter (1) according to any one of claims 1 to 3 wherein said meter comprises a microcontroller (7), said means for memorizing being integrated in said microcontroller.

5. Meter (1) according to any one of claims 1 to 4 wherein said phase compensation means (9) are a timer integrated in said analogue to digital converter (8).
